# FASCICULE DE BREVET EUROPEEN

(11) **EP 4 026 408 B1**
(45) Date de publication et mention de la délivrance du brevet: **20.08.2025**
(21) Numéro de dépôt: 20771244.9
(22) Date de dépôt: 07.09.2020
(51) Int. Cl.: H05K 7/14

(54) **CARTE ÉLECTRONIQUE POUR CONVERTISSEUR DE TENSION**
ELEKTRONISCHE PLATINE FÜR SPANNUNGSWANDLER
ELECTRONIC BOARD FOR VOLTAGE CONVERTER

(30) Priorité: 06.09.2019 FR 1909850
(43) Date de publication de la demande: 13.07.2022
(73) Titulaire: Valeo Electrification, 95800 Cergy (FR)
(72) Inventeur: ALLALI, Nicolas, 95892 Cergy Pontoise (FR); TALON, Emmanuel, 95892 Cergy Pontoise (FR)
(74) Mandataire: Valeo Powertrain Systems
(86) Numéro de dépôt international: PCT/EP2020/074981
(87) Numéro de publication internationale: WO 2021/044062

(56) Documents cités:
- EP-A1- 3 312 983
- EP-A2- 2 685 796
- WO-A1-2015/029630
- US-B1- 6 501 172

## Description

La présente invention concerne une carte électronique définissant plusieurs bras de commutation, notamment pour réaliser un convertisseur de tension. Le convertisseur de tension est par exemple un convertisseur de tension continue/continue, ou encore un onduleur/redresseur.

De tels bras de commutation mettent classiquement en œuvre des transistors. Les nouvelles technologies de transistors à base de nitrure de gallium (GaN) ou à base de carbure de silicium (SiC) atteignent des performances en termes de vitesse de commutation bien plus élevées que les technologies précédentes, ce qui permet de travailler à des fréquences de découpage plus élevées.

Les bras de commutation sont agencés pour convertir une tension continue en une autre tension, qui peut ou non être également une tension continue. Des condensateurs de découplage sont connectés en parallèle de cette tension continue et, du fait des fréquences de découpage précitées, des harmoniques hautes fréquences sont générées. La présence d'inductances parasites dans les liaisons entre les condensateurs de découplage peut, du fait de ces harmoniques, générer des résonances en courant, ce qui peut dégrader des composants de la carte électronique.

Les documents EP2685796A2 et US6501172B1 montrent des exemples connus de cartes électroniques pour convertisseur de tension.

Il existe un besoin pour bénéficier d'une carte électronique remédiant à l'inconvénient précité.

L'invention a pour objet de répondre à ce besoin et elle y parvient, selon l'un de ses aspects, à l'aide d'une carte électronique, définissant plusieurs bras de commutation connectés en parallèle pour convertir une première tension en une deuxième tension, l'une de ces tensions au moins étant une tension continue, la carte comprenant :
- une pluralité d'interrupteurs électroniques commandables montés deux à deux en série de part et d'autre d'un point milieu, de manière à réaliser les bras de commutation connectés en parallèle,
- une pluralité de condensateurs de découplage, ces condensateurs étant connectés en parallèle entre eux, et en parallèle de la tension continue, et
- deux couches électriquement conductrices, l'une de ces couches électriquement conductrices étant électriquement au potentiel le plus élevé de la tension continue et l'autre de ces couches électriquement conductrices étant au potentiel le moins élevé de la tension continue, chacun des condensateurs de découplage ayant une borne reliée à l'une de ces couches électriquement conductrices et son autre borne reliée à l'autre de ces couches électriquement conductrices,
les interrupteurs électroniques étant disposés sur la carte de manière à ce que le motif reliant tous les points milieux des bras de commutation définisse un premier polygone dont le nombre de côtés est supérieur ou égal à 3, et chacune de ces deux couches électriquement conductrices s'étendant au moins sur une surface superposée au premier polygone.

La carte électronique selon l'invention présente d'une part une liaison entre condensateurs de découplage qui se fait via des couches électriquement conductrices superposées, et non des conducteurs filaires ou des pistes résistives de carte de circuit imprimé et d'autres part des bras de commutation disposés de manière non alignée. De cette façon, on réduit significativement les inductances parasites des liaisons entre les condensateurs de découplage, et ainsi les résonances en courant précitées. Par ailleurs, le positionnement sur la carte des interrupteurs électroniques de manière à ce que le motif reliant tous les points milieux des bras de commutation définisse un premier polygone peut permettre de réduire le déséquilibre des distances effectives entre les bras de commutation et les condensateurs de découplage.

Dans tout ce qui suit, et sauf en cas de mention contraire explicite :
- le terme « connecté » se réfère à une connexion électrique tandis que le terme « disposé » se réfère à une disposition spatiale, et
- deux polygones sont de même type lorsqu'ils ont le même nombre de côtés.

Selon l'invention, tous les bras de commutation sont disposés de manière à se faire face spatialement parlant, c'est-à-dire qu'aucun bras de commutation n'est interposé spatialement entre deux autres bras de commutation de la carte électronique.

Les couches électriquement conductrices peuvent être disposées en parallèle entre elles.

Chaque couche électriquement conductrice peut se présenter sous la forme d'une plaque, cette plaque s'étendant entre deux surfaces parallèles entre elles.

La carte électronique est par exemple une carte de circuit imprimé. Chaque condensateur de découplage et les interrupteurs électroniques sont par exemple montés sur une même surface d'extrémité de cette carte de circuit imprimé.

L'une au moins de la première et de la deuxième couche électriquement conductrice peut être disposée à l'intérieur de la carte de circuit imprimé. L'une des couches électriquement conductrices est par exemple une couche définissant une surface extérieure de la carte de circuit imprimé, par exemple la surface supérieure ou la surface inférieure tandis que l'autre couche électriquement conductrice est une couche disposée à l'intérieur de cette carte de circuit imprimé.

En variante, chacune des couches électriquement conductrices est disposée à l'intérieur de la carte de circuit imprimé.

En variante encore, chacune des couches électriquement conductrices est une couche définissant une surface extérieure de la carte de circuit imprimé, l'une de ces couches étant la surface supérieure de cette carte de circuit imprimé et l'autre de ces couches étant la surface inférieure de cette carte de circuit imprimé.

Toujours dans le cas d'une portion de carte de circuit imprimé et lorsque chacune de la première et de la deuxième couche électriquement conductrice est disposée à l'intérieur de la portion de carte de circuit imprimé, ces deux couches électriquement conductrices peuvent définir entre elles un condensateur haute fréquence, ayant notamment une inductance propre inférieure à 1 nH, comme divulgué dans la demande déposée en France le 1er avril 2019 sous le numéro 19 03457 par la Demanderesse.

La première couche électriquement conductrice peut comprendre plusieurs sous-couches connectées en parallèle. Seules certaines sous-couches de la première couche électriquement conductrice, ou la totalité de ces sous-couches, peuvent être disposées à l'intérieur de la carte de circuit imprimé. La deuxième couche électriquement conductrice peut comprendre plusieurs sous-couches connectées en parallèle. Seules certaines sous-couches de la deuxième couche électriquement conductrice, ou la totalité de ces sous-couches, peuvent être disposées à l'intérieur de la carte de circuit imprimé.

Le cas échéant, la carte électronique peut comprendre une alternance de sous-couche de la première couche électriquement conductrice et de sous-couche de la deuxième couche électriquement conductrice, ces sous-couches étant alors empilées.

Dans tout ce qui précède, et notamment lorsque l'une au moins des couches électriquement conductrices est disposée à l'intérieur d'une carte de circuit imprimé, un ou plusieurs vias peut être ménagé pour permettre la connexion électrique entre une borne d'un condensateur et la couche électriquement conductrice correspondante. Chaque via est par exemple formé par un trou métallisé ou par un via laser.

Chaque interrupteur électronique commandable d'un bras de commutation peut occuper l'une d'une position en éloignement du centre du premier polygone par rapport au point milieu dudit bras et d'une position en rapprochement du centre du premier polygone par rapport audit point milieu.

Dans tout ce qui précède, les condensateurs de découplage peuvent être disposés sur la carte de manière à ce que le motif reliant tous ces condensateurs définisse un deuxième polygone. Le nombre de côtés de ce deuxième polygone peut être supérieur ou égal à trois.

Le nombre de condensateurs de découplage peut être égal au nombre de bras de commutation, auquel cas le premier polygone et le deuxième polygone sont de même type.

Le deuxième polygone peut être contenu à l'intérieur, ou au moins majoritairement à l'intérieur, du premier polygone, ou le premier polygone peut être contenu à l'intérieur, ou au moins majoritairement à l'intérieur, du deuxième polygone. Le fait que le deuxième polygone soit en tout ou partie à l'intérieur du premier polygone peut permettre de réduire les distances effectives entre les condensateurs de découplage associés au motif définissant ce deuxième polygone. Cette position peut par ailleurs augmenter la valeur de l'inductance mutuelle entre ces condensateurs de découplage deux à deux.

Selon un exemple particulier de mise en œuvre de l'invention, chacune de la première tension et de la deuxième tension peut être une tension continue. La première tension continue peut être supérieure à la deuxième tension continue. Les bras de commutation convertissent alors par exemple :
- une première tension de 48V en une deuxième tension de 12V, et réciproquement ou non, ou
- une première tension de valeur supérieure à 300V en une deuxième tension de 12V, et réciproquement ou non.

Lorsque les bras de commutation réalisent une conversion continue/continue, une pluralité de condensateurs de découplage est présente et condensateurs sont connectés en parallèle entre eux, et en parallèle de la première tension continue, et une pluralité de condensateurs de découplage est présente et ces condensateurs sont connectés en parallèle entre eux et en parallèle de la deuxième tension continue, une des pluralités de condensateurs étant disposée sur la carte de manière à ce que le motif reliant tous ces condensateurs définisse le deuxième polygone et l'autre des pluralité de condensateurs étant disposée sur la carte de manière à ce que le motif reliant tous ces condensateurs définisse un troisième polygone. Le deuxième et le troisième polygone peuvent tous deux avoir un nombre de côtés, égal ou non du deuxième au troisième polygone, qui est supérieur ou égal à trois.

Chaque pluralité de condensateurs peut comprendre un nombre de condensateurs égal au nombre de bras de commutation, auquel cas le troisième polygone, le deuxième polygone et le premier polygone sont de même type.

Toujours lorsque les bras de commutation réalisent une conversion continue/continue, le troisième polygone peut être contenu à l'intérieur, ou au moins majoritairement à l'intérieur, du premier polygone ou le premier polygone peut être contenu à l'intérieur, ou au moins majoritairement à l'intérieur, du troisième polygone. Le fait que le troisième polygone soit en tout ou partie à l'intérieur du premier polygone peut permettre de réduire les distances effectives entre les condensateurs de découplage associés au motif définissant le troisième polygone.

Lorsque chacun des polygones précités est disposé à l'intérieur d'un autre de ces polygones, on parlera de configuration imbriquée des condensateurs de découplage par rapport aux interrupteurs électroniques commandables.

Toujours lorsque les bras de commutation réalisent une conversion continue/continue, le deuxième polygone peut être contenu à l'intérieur, ou au moins majoritairement à l'intérieur, du premier polygone, et le premier polygone peut être contenu à l'intérieur, ou au moins majoritairement à l'intérieur, du troisième polygone. De telles positions relatives du premier, deuxième et troisième polygone peuvent être particulièrement avantageuses pour de très hautes fréquences de découpage, par exemple supérieures à 1 MHz.

Dans tout ce qui précède, la carte électronique peut comprendre une pluralité d'inductances, chaque inductance étant associée à un bras de commutation et électriquement reliée au point milieu dudit bras. Les inductances peuvent être ou non disposées sur la carte de manière à ce que le motif reliant toutes ces inductances définisse un quatrième polygone. En variante, le motif reliant toutes ces inductances définit une ligne.

Le nombre d'inductances peut être égal au nombre de bras de commutation, auquel cas le quatrième polygone est de même type que le premier polygone. Ces inductances sont par exemple portées par la même surface de la carte électronique que les condensateurs de découplage et les interrupteurs électroniques.

Le quatrième polygone peut être contenu à l'intérieur, ou au moins majoritairement à l'intérieur, du premier polygone, ou le premier polygone peut être contenu à l'intérieur, ou au moins majoritairement à l'intérieur, du quatrième polygone.

Toujours dans le cas où les bras de commutation réalisent une conversion continue/continue, la première tension continue peut être définie entre un premier potentiel positif et la masse, et la deuxième tension continue peut être définie entre un deuxième potentiel positif et la masse, et la carte électronique comprend alors:
- une première couche électriquement conductrice au premier potentiel positif,
- une deuxième couche électriquement conductrice au deuxième potentiel positif, et
- une troisième couche électriquement conductrice à la masse

deux au moins des couches électriquement conductrices, la première et la deuxième couche électriquement conductrice, notamment toutes les couches électriquement conductrices, s'étendant au moins sur une surface superposée au premier polygone, ou
deux au moins desdites couches électriquement conductrices, notamment la première et la deuxième couche électriquement conductrice, s'étendant au moins sur une surface superposée au premier et au deuxième et au troisième polygone.

Tout ce qui a été mentionné ci-dessus en rapport avec la disposition de la première et de la deuxième couche électriquement conductrice à l'intérieur ou non d'une carte de circuit imprimé ou sous la forme de plusieurs sous-couches s'applique encore lorsqu'il y a trois couches électriquement conductrices.

Les tensions continues peuvent avoir une masse isolée, auquel cas deux troisièmes couches électriquement conductrices isolées entre elles sont prévues, l'une formant la masse de la première tension continue, et l'autre formant la masse de la deuxième tension continue. Dans un tel cas, la carte électronique peut comprendre une première zone dans laquelle sont superposées la première couche électriquement conductrice et la troisième couche électriquement conductrice formant la masse de la première tension continue, et une deuxième zone de la carte distincte de la première zone dans laquelle sont superposées la deuxième couche électriquement conductrice et la troisième couche électriquement conductrice formant la masse de la deuxième tension continue.

Dans le cas où trois couches électriquement conductrices sont prévues, l'un du premier, deuxième, troisième et quatrième polygones peut contenir tous les autres polygones, et deux au moins des couches électriquement conductrices, notamment la première et la deuxième couche électriquement conductrice, notamment toutes les couches électriquement conductrices, peut s'étendre au moins sur une surface superposée à ce polygone à l'intérieur duquel sont disposés tous les autres polygones.

Quel que soit le nombre de couches conductrices prévues, un polygone peut circonscrire tous les condensateurs, les inductances et interrupteurs électroniques commandables de l'ensemble des bras de commutation et deux au moins des couches électriquement conductrices, notamment la première et la deuxième couche électriquement conductrice, notamment toutes les couches électriquement conductrices, peut s'étendre au moins sur une surface superposée à ce polygone. Dans le cas où trois couches électriquement conductrices sont prévues, chaque condensateur de la pluralité de condensateurs définissant le deuxième polygone peut avoir une borne électriquement connectée à la première couche électriquement conductrice et son autre borne électriquement connectée à la troisième couche électriquement conductrice, et chaque condensateur de la pluralité de condensateurs définissant le troisième polygone peut avoir une borne électriquement connectée à la deuxième couche électriquement conductrice et son autre borne électriquement connectée à la troisième couche électriquement conductrice.

Le cas échéant, deux condensateurs disposés en parallèle d'une même tension continue peuvent avoir leurs bornes correspondantes connectées électriquement de façon opposée, c'est-à-dire que l'un de ces deux condensateurs a sa première borne électriquement connectée à la première couche électriquement conductrice et sa deuxième borne connectée à la troisième couche électriquement conductrice, tandis que l'autre de ces deux condensateurs a sa première borne électriquement connectée à la troisième couche électriquement conductrice et sa deuxième borne connectée à la première couche électriquement conductrice, selon l'enseignement de la demande déposée le 1er août 2019 en France par la présente Déposante de numéro de dépôt 19 08805 dont le contenu est incorporé par référence à la présente demande.

Dans tout ce qui précède, chaque couche électriquement conductrice peut être réalisée en cuivre, étant par exemple une plaque de cuivre.

Dans tout ce qui précède, les différentes couches électriquement conductrices peuvent être disposées spatialement de manière parallèle entre elles.

Dans tout ce qui précède, chaque interrupteur commandable peut être un transistor utilisant du nitrure de gallium (GaN) ou du carbure de silicium (SiC) ou du silicium.

Dans tout ce qui précède, le nombre de bras de commutation peut être quelconque, dès lors qu'il est supérieur ou égal à 3, étant par exemple compris entre 3 et 6.

L'invention a encore pour objet, selon un autre de ses aspects, un convertisseur de tension, notamment un convertisseur de tension continue/continue, notamment convertisseur de tension continue 12V/48V ou 12V/tension supérieure à 300V, comprenant une carte électronique telle que définie ci-dessus.

En variante, le convertisseur de tension est un onduleur/redresseur, auquel cas la tension continue a par exemple une valeur de 12V ou de 48V ou de valeur supérieure à 300V.

Le convertisseur de tension peut permettre la charge d'une source de tension continue depuis un réseau de tension alternatif.

L'invention pourra être mieux comprise à la lecture de la description qui va suivre d'exemples non limitatifs de mise en œuvre de celle-ci et à l'examen du dessin annexé sur lequel :
- la figure 1 représente le schéma électrique d'un circuit formé par une carte électronique selon un exemple de mise en œuvre de l'invention,
- la figure 2 représente une vue de dessus d'une carte électronique selon l'exemple de la figure 1,
- la figure 3 est une coupe partielle selon III-III de la carte électronique de la figure 2,
- la figure 4 est une coupe partielle selon IV-IV de la carte électronique de la figure 2,
   et
- les figures 5 et 6 représentent similairement à la figure 2 des cartes électroniques selon d'autres exemples de mise en œuvre de l'invention.

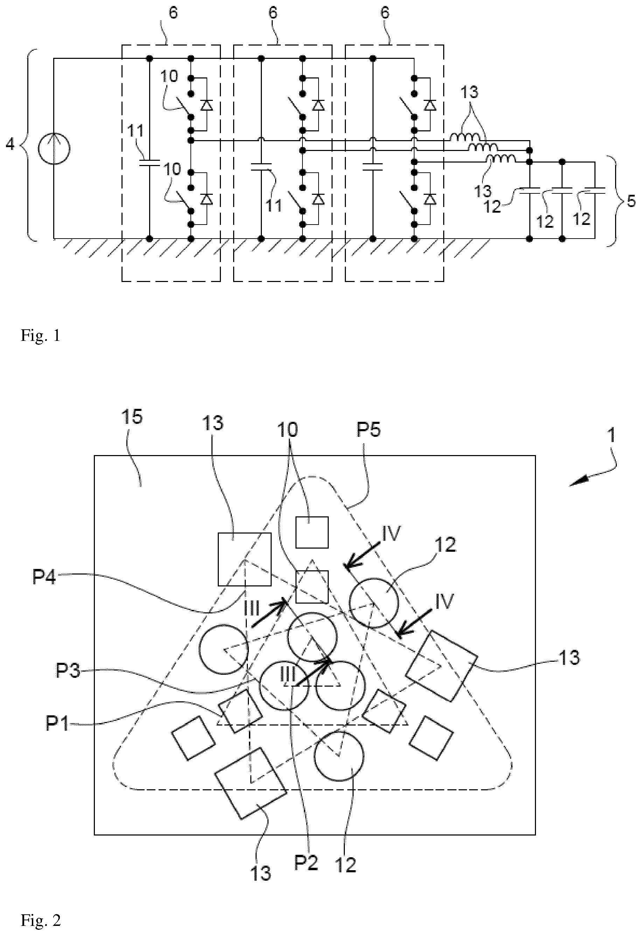

On a représenté à la figure 1 le circuit électrique porté par une carte électronique 1 selon un exemple de mise en œuvre de l'invention. Cette carte électronique 1 fait ici partie d'un convertisseur de tension qui est dans l'exemple considéré un convertisseur de tension continue/continue. Il s'agit par exemple d'un convertisseur de tension 12V/48V mais l'invention n'est pas limitée à un tel exemple. La carte électronique 1 est ici une carte de circuit imprimé.

De façon connue, le convertisseur de tension comprend ici une première entrée en tension continue 4, une deuxième entrée de tension continue 5 et plusieurs bras de commutation 6 permettant de convertir la valeur de tension sur la première entrée en tension continue 4 en une autre valeur de tension disponible sur la deuxième entrée en tension continue 5, et réciproquement. Le nombre de bras de commutation 6 est supérieur ou égal à trois, étant ici exactement égal à trois.

Chaque bras de commutation 6 comprend dans l'exemple considéré deux interrupteurs électroniques commandables 10 qui sont connectés en série et qui définissent entre eux un point milieu relié à la deuxième entrée en tension 5.

Chaque interrupteur commandable 10 est ici un transistor MOSFET, utilisant par exemple du nitrure de galium, du carbure de silicium ou du silicium.

Le composant électronique 1 comprend encore :
- une première pluralité de condensateurs de découplage 11, ces condensateurs 11 étant tous connectés en parallèle, et en parallèle du bras de commutation 6, et
- une deuxième pluralité de condensateurs de découplage 12, ces condensateurs étant tous connectés en parallèle, et en parallèle de la deuxième entrée en tension continue 5.

Les condensateurs 11 et les condensateurs 12 sont par exemple du même type, à savoir notamment des condensateurs chimiques ou des condensateurs en céramique.

On constate encore sur la figure 1 que le circuit électrique comprend encore une pluralité d'inductances 13, chaque inductance étant associée à un bras de commutation 6 et connectée électriquement entre le point milieu du bras 6 auquel elle est associée et le potentiel le plus élevé de la deuxième tension continue.

Dans l'exemple considéré, il y a autant de condensateurs 11, qu'il y a de condensateurs 12, qu'il y a d'inductances 13, cette valeur commune étant égale au nombre de bras de commutation 6. L'invention n'est cependant pas limitée à une telle valeur commune pour les composants précités.

Comme on peut le voir sur la figure 2, les condensateurs 11, les condensateurs 12, les inductances 13 et les interrupteurs électroniques commandables 10 sont montés dans l'exemple considéré sur une surface extérieure 15 de la carte électronique 1.

La carte électronique 1 reçoit dans l'exemple de la figure 2 trois couches électriquement conductrices étant respectivement :
- une première couche électriquement conductrice 16 au potentiel le plus élevé de la première tension continue, encore appelé « premier potentiel positif » et qui est ici à 48V,
- une deuxième couche électriquement conductrice 17 au potentiel le plus élevé de la deuxième tension continue, encore appelé « deuxième potentiel positif » et qui est ici à 12V, et
- une troisième couche électriquement conductrice 18 à la masse, cette masse étant ici commune à la première tension continue et à la deuxième tension continue.

Dans une variante non décrite, la première tension continue et la deuxième tension continue ont des masses isolées, auquel cas deux troisièmes couches électriquement conductrices 18 non reliées entre elles sont prévues, l'une de ces troisièmes couches électriquement conductrice formant la masse de la première tension continue et l'autre de ces troisièmes couches électriquement conductrices formant la masse de la deuxième tension continue.

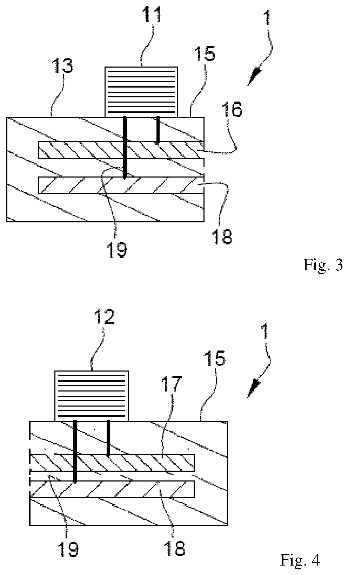

Les condensateurs 11 ont dans l'exemple considéré chacun une borne électriquement connectée à la première couche électriquement conductrice 16 et une borne électriquement connectée à la troisième couche électriquement conductrice 18, comme représenté sur la figure 3 sur laquelle la deuxième couche électriquement conductrice 17 a été omise pour des raisons de clarté du dessin.

Les condensateurs 12 ont dans l'exemple considéré chacun une borne électriquement connectée à la deuxième couche électriquement conductrice 17 et une borne électriquement connectée à la troisième couche électriquement conductrice 18, comme représenté sur la figure 4 sur laquelle la première couche électriquement conductrice 16 a été omise pour des raisons de clarté du dessin.

On constate que, dans l'exemple considéré, la première couche électriquement conductrice 16 s'étend dans des plans qui sont parallèles aux plans dans lesquels s'étend la deuxième couche électriquement conductrice 17, et également parallèles aux plans dans lesquels s'étend la troisième couche électriquement conductrice 18. Chacune de ces couches 16, 17 et 18 est ici formée par une plaque en cuivre. Chacune de ces couches 16, 17 et 18 est également disposée à l'intérieur de la carte électronique 1, et la connexion d'une borne de condensateur à la couche électriquement conductrice correspondante se fait ici par l'intermédiaire d'un via 19 étant un trou métallisé.

Dans les exemples qui vont maintenant être décrits, les bras de commutation 6 et donc leurs interrupteurs électroniques 10 sont disposés sur la carte 1 de manière à ce que le motif reliant tous les points milieux des bras de commutation 6 définisse un premier polygone P1 dont le nombre de côtés est supérieur ou égal à 3, et chaque couche électriquement conductrice 16, 17 et 18 s'étend au moins sur une surface superposée au premier polygone.

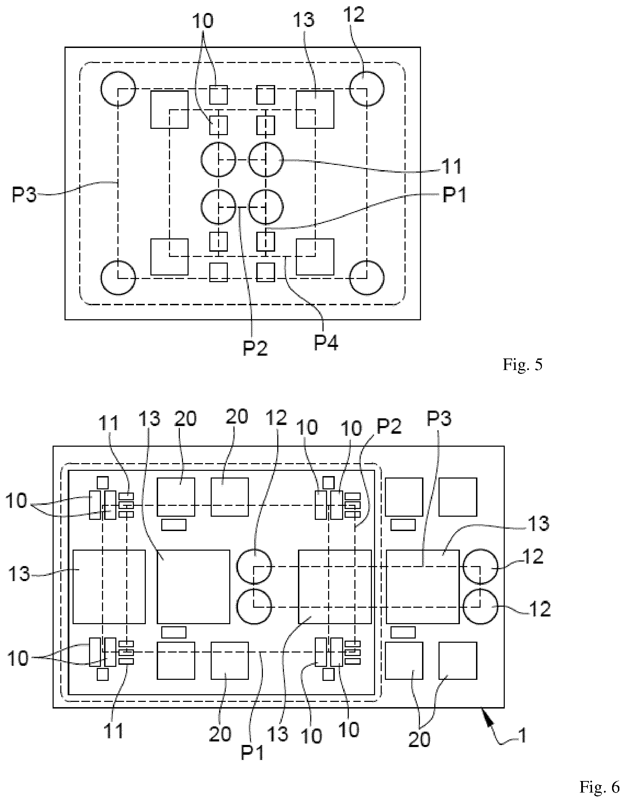

Dans l'exemple de la figure 2, ce premier polygone est un triangle tandis qu'il s'agit d'un quadrilatère dans les exemples des figures 5 et 6.

On constate sur la figure 2 que pour un bras de commutation 6 donné, l'un des interrupteurs électroniques commandables 10 est disposé à l'extérieur du premier polygone P1 tandis que l'autre interrupteur électronique commandable 10 est disposé à l'intérieur de ce premier polygone P1.

On constate également que les condensateurs 11 associés à la première entrée en tension continue 4 sont disposés sur la carte 1 de manière à ce que le motif reliant tous ces condensateurs 11 définisse un deuxième polygone P2, ce deuxième polygone P2 étant ici un triangle.

On constate sur la figure 2 que ce deuxième polygone P2 est disposé à l'intérieur du premier polygone P1.

Toujours dans l'exemple de la figure 2, les condensateurs 12 associés à la deuxième entrée en tension continue 5 sont disposés sur la carte 1 de manière à ce que le motif reliant tous ces condensateurs 12 définisse un troisième polygone P3, ce troisième polygone P3 étant ici également un triangle. On constate sur la figure 2 que le troisième polygone P3 s'étend pour certaines parties à l'intérieur du premier polygone P1 et pour d'autres parties à l'extérieur de ce premier polygone P1. Dans l'exemple de la figure 2, le troisième polygone P3 s'étend majoritairement à l'intérieur du premier polygone P1.

Par ailleurs, dans l'exemple de la figure 2, les inductances 13 sont disposées sur la carte 1 de manière à ce que le motif reliant toutes ces inductances 13 définisse un quatrième polygone P4, le quatrième polygone étant ici également un triangle. On constate que ce quatrième polygone s'étend pour certaines parties à l'intérieur du premier polygone P1 et pour certaines parties à l'extérieur de ce polygone P1.

Chacune des couches électriquement conductrices 16, 17 et 18 s'étend dans l'exemple décrit sur une surface superposée au polygone P5 dans lequel les composants 10, 11, 12 et 13 de la carte sont disposés, tous les polygones P1 à P4 étant disposés à l'intérieur de ce polygone P5.

Dans l'exemple des figures 5 et 6, quatre bras de commutation 6 sont présents, quatre condensateurs 11 sont associés à la première entrée en tension continue 4, et quatre condensateurs 12 et quatre inductances 13 sont associées à la deuxième entrée en tension continue 5.

On constate là encore la présence de premier P1, deuxième P2, troisième P3 et quatrième polygone P4 qui sont ici des quadrilatères.

Dans l'exemple de la figure 5, le deuxième polygone P2 relatif aux condensateurs 11 associés à la première entrée en tension continue 4 est disposé à l'intérieur du premier polygone P1, ce premier polygone P1 étant lui-même disposé à l'intérieur du quatrième polygone P4 relatif aux inductances 13, et ce quatrième polygone P4 étant disposé à l'intérieur du troisième polygone P3 relatif aux condensateurs 12 associés à la deuxième entrée en tension continue 5. Le positionnement le plus à l'intérieur possible des condensateurs 11 permet d'augmenter la valeur de l'inductance mutuelle entre ces condensateurs 11 deux à deux.

La figure 6 montre un autre exemple de carte électronique 1 dans lequel les polygones P1 à P3 sont encore des quadrilatères. Contrairement aux exemples précédents, les inductances 13 ne sont pas reliées par un motif définissant un polygone mais une ligne. On constate par ailleurs qu'aucun des polygones P1, P2 et P3 n'est contenu à l'intérieur d'un autre polygone, le polygone P1 chevauchant le polygone P2 et le polygone P3 chevauchant chacun du polygone P1 et du polygone P2. On constate encore sur la figure 6 que des transistors de sécurité 20 sont portés par la carte électronique 1.

## Revendications

1. Carte électronique (1), définissant plusieurs bras de commutation (6) connectés en parallèle pour convertir une première tension en une deuxième tension, l'une de ces tensions au moins étant une tension continue, la carte comprenant :
- une pluralité d'interrupteurs électroniques commandables (10) montés deux à deux en série de part et d'autre d'un point milieu, de manière à réaliser les bras de commutation connectés en parallèle,
- une pluralité de condensateurs de découplage (11, 12), ces condensateurs (11) étant connectés en parallèle entre eux, et en parallèle de la tension continue, et **caractérisée par**
- deux couches électriquement conductrices (16, 17, 18), notamment disposées de façon parallèle entre elles, l'une de ces couches électriquement conductrices (16) étant électriquement au potentiel le plus élevé de la tension continue et l'autre de ces couches électriquement conductrice (18) étant au potentiel le moins élevé de la tension continue, chacun des condensateurs de découplage (11, 12) ayant une borne reliée à l'une de ces couches électriquement conductrices (16) et son autre borne reliée à l'autre de ces couches électriquement conductrices (18),
les interrupteurs électroniques (10) étant disposés sur la carte de manière à ce que le motif reliant tous les points milieux des bras de commutation (6) définisse un premier polygone (P1) dont le nombre de côtés est supérieur ou égal à 3, et chacune des deux couches électriquement conductrices (16, 17, 18) s'étendant au moins sur une surface superposée au premier polygone (P1).

2. Carte électronique selon la revendication 1, chaque interrupteur électronique commandable (10) d'un bras de commutation occupant l'une d'une position en éloignement du centre du premier polygone (P1) par rapport au point milieu dudit bras et d'une position en rapprochement du centre du premier polygone (P1) par rapport audit point milieu.

3. Carte électronique selon la revendication 1 ou 2, les condensateurs de découplage (11) étant disposés sur la carte de manière à ce que le motif reliant tous ces condensateurs définisse un deuxième polygone (P2), ce deuxième polygone étant notamment de même type que le premier polygone (P1).

4. Carte électronique selon la revendication 3, le deuxième polygone (P2) étant contenu à l'intérieur, ou au moins majoritairement à l'intérieur, du premier polygone (P1), ou le premier polygone (P1) étant contenu à l'intérieur, ou au moins majoritairement à l'intérieur, du deuxième polygone (P2).

5. Carte électronique selon l'une quelconque des revendications précédentes, chacune de la première tension et de la deuxième tension étant une tension continue, la première tension continue étant notamment supérieure à la deuxième tension continue.

6. Carte électronique selon la revendication 5, comprenant une pluralité de condensateurs de découplage (11) connectés en parallèle entre eux, et en parallèle de la première tension continue, et une pluralité de condensateurs de découplage (12) connectés en parallèle entre eux et en parallèle de la deuxième tension continue, une des pluralités de condensateurs (11) étant disposée sur la carte de manière à ce que le motif reliant tous ces condensateurs définisse le deuxième polygone (P2) et l'autre des pluralité de condensateurs (12) étant disposée sur la carte de manière à ce que le motif reliant tous ces condensateurs définisse un troisième polygone (P3), le troisième polygone étant notamment de même type que le premier et le deuxième polygone.

7. Carte électronique selon la revendication 6, le troisième polygone (P3) étant contenu à l'intérieur, ou au moins majoritairement à l'intérieur, du premier polygone (P1), ou le premier polygone (P1) étant contenu à l'intérieur, ou au moins majoritairement à l'intérieur, du troisième polygone (P3).

8. Carte électronique selon la revendication 6, le deuxième polygone (P2) étant contenu à l'intérieur, ou au moins majoritairement à l'intérieur, du premier polygone (P1), et le premier polygone (P1) étant contenu à l'intérieur, ou au moins majoritairement à l'intérieur, du troisième polygone (P3).

9. Carte électronique selon l'une quelconque des revendications 6 à 8, comprenant une pluralité d'inductances (13), chaque inductance (13) étant associée à un bras de commutation (6) et électriquement reliée au point milieu dudit bras, les inductances (13) étant disposées sur la carte de manière à ce que le motif reliant toutes ces inductances définisse un quatrième polygone (P4), le quatrième polygone étant notamment de même type que le premier polygone.

10. Carte électronique selon l'une quelconque des revendications 6 à 9, la première tension continue étant définie entre un premier potentiel positif et la masse, et la deuxième tension continue étant définie entre un deuxième potentiel positif et la masse, la carte (1) comprenant :
- une première couche électriquement conductrice (16) au premier potentiel positif,
- une deuxième couche électriquement conductrice (17) au deuxième potentiel positif, et
- une troisième couche électriquement conductrice (18) à la masse
deux au moins des couches électriquement conductrices (16, 17, 18), notamment toutes les couches électriquement conductrices, s'étendant au moins sur une surface superposée au premier polygone (P1).

11. Carte électronique selon les revendications 9 et 10, l'un du premier, deuxième, troisième et quatrième polygones contenant tous les autres polygones, et deux au moins des couches électriquement conductrices, notamment toutes les couches électriquement conductrices, s'étendant au moins sur une surface superposée à ce polygone à l'intérieur duquel sont disposés tous les autres polygones.

12. Carte électronique selon la revendication 10 ou 11, chaque condensateur de la pluralité de condensateurs (11) définissant le deuxième polygone (P2) ayant une borne électriquement connectée à la première couche électriquement conductrice (16) et son autre borne électriquement connectée à la troisième couche électriquement conductrice (18), et chaque condensateur (12) de la pluralité de condensateurs définissant le troisième polygone (P3) ayant une borne électriquement connectée à la deuxième couche électriquement conductrice (17) et son autre borne électriquement connectée à la troisième couche électriquement conductrice (18).

13. Convertisseur de tension, notamment convertisseur de tension continue/continue, notamment convertisseur de tension continue 12V/48V, comprenant une carte électronique selon l'une quelconque des revendications précédentes.

## Patentansprüche

1. Elektronische Platine (1), die mehrere parallel Schaltarme (6) definiert, um eine erste Spannung in eine zweite Spannung umzuwandeln, wobei eine dieser Spannungen mindestens eine kontinuierliche Spannung ist, wobei die Platine Folgendes umfasst:
• eine Vielzahl von elektronisch steuerbaren Schaltern (10), die zu zwei in Reihe geschalteten Gruppen auf beiden Seiten eines Mittelpunkts angeordnet sind, um die parallel Schaltarme zu bilden,
• eine Vielzahl von Entkopplungskondensatoren (11, 12), wobei diese Kondensatoren (11) parallel zueinander und parallel zur kontinuierlichen Spannung geschaltet sind und **gekennzeichnet sind durch**
• zwei elektrisch leitfähige Schichten (16, 17, 18), insbesondere parallel zueinander angeordnet, wobei eine dieser elektrisch leitfähigen Schichten (16) elektrisch auf dem höheren Potenzial der kontinuierlichen Spannung und die andere dieser elektrisch leitfähigen Schichten (18) auf dem niedrigeren Potenzial der kontinuierlichen Spannung liegt, wobei jeder der Entkopplungskondensatoren (11, 12) einen Anschluss hat, der mit einer der elektrisch leitfähigen Schichten (16) verbunden ist, und einen anderen Anschluss, der mit der anderen der elektrisch leitfähigen Schichten (18) verbunden ist,
wobei die elektronischen Schalter (10) so auf der Platine angeordnet sind, dass das Verbindungsmuster aller Mittelpunkte der Schaltarme (6) ein erstes Polygon (P1) definiert, dessen Eckenanzahl größer oder gleich 3 ist, und wobei jede der beiden elektrisch leitfähigen Schichten (16, 17, 18) sich zumindest über eine Oberfläche erstreckt, die dem ersten Polygon (P1) überlagert ist.

2. Elektronische Platine nach Anspruch 1, wobei jeder elektronisch steuerbare Schalter (10) eines Schaltarms: eine Position weiter vom Mittelpunkt des ersten Polygons (P1) relativ zum Mittelpunkt des genannten Arms oder eine Position näher am Mittelpunkt des ersten Polygons (P1) relativ zu diesem Mittelpunkt einnimmt.

3. Elektronische Platine nach Anspruch 1 oder 2, wobei die Entkopplungskondensatoren (11) so auf der Platine angeordnet sind, dass das Verbindungsmuster all dieser Kondensatoren ein zweites Polygon (P2) definiert, wobei das zweite Polygon insbesondere vom gleichen Typ wie das erste Polygon (P1) ist.

4. Elektronische Platine nach Anspruch 3, wobei das zweite Polygon (P2) innerhalb oder zumindest größtenteils innerhalb des ersten Polygons (P1) enthalten ist, oder das erste Polygon (P1) innerhalb oder zumindest größtenteils innerhalb des zweiten Polygons (P2) enthalten ist.

5. Elektronische Platine nach einem der vorhergehenden Ansprüche, wobei jede der ersten Spannung und der zweiten Spannung eine kontinuierliche Spannung ist, wobei die erste kontinuierliche Spannung insbesondere höher ist als die zweite kontinuierliche Spannung.

6. Elektronische Platine nach Anspruch 5, umfassend eine Vielzahl von Entkopplungskondensatoren (11), die parallel zueinander und parallel zur ersten Spannung geschaltet sind, und eine Vielzahl von Entkopplungskondensatoren (12), die parallel zueinander und parallel zur zweiten kontinuierlichen Spannung geschaltet sind, wobei eine der Vielzahlen von Kondensatoren (11) so auf der Platine angeordnet ist, dass das Verbindungsmuster all dieser Kondensatoren das zweite Polygon (P2) definiert, und die andere Vielzahl von Kondensatoren (12) so auf der Platine angeordnet ist, dass das Verbindungsmuster all dieser Kondensatoren ein drittes Polygon (P3) definiert, wobei das dritte Polygon insbesondere vom gleichen Typ wie das erste und zweite Polygon ist.

7. Elektronische Platine nach Anspruch 6, wobei das dritte Polygon (P3) innerhalb oder zumindest größtenteils innerhalb des ersten Polygons (P1) enthalten ist, oder das erste Polygon (P1) innerhalb oder zumindest größtenteils innerhalb des dritten Polygons (P3) enthalten ist.

8. Elektronische Platine nach Anspruch 6, wobei das zweite Polygon (P2) innerhalb oder zumindest größtenteils innerhalb des ersten Polygons (P1) enthalten ist, und das erste Polygon (P1) innerhalb oder zumindest größtenteils innerhalb des dritten Polygons (P3) enthalten ist.

9. Elektronische Platine nach einem der Ansprüche 6 bis 8, umfassend eine Vielzahl von Induktivitäten (13), wobei jede Induktivität (13) einem Schaltarm (6) zugeordnet und elektrisch mit dem Mittelpunkt des genannten Arms verbunden ist, wobei die Induktivitäten (13) so auf der Platine angeordnet sind, dass das Verbindungsmuster all dieser Induktivitäten ein viertes Polygon (P4) definiert, wobei das vierte Polygon insbesondere vom gleichen Typ wie das erste Polygon ist.

10. Elektronische Platine nach einem der Ansprüche 6 bis 9, wobei die erste kontinuierliche Spannung zwischen einem ersten positiven Potenzial und Masse definiert ist, und die zweite kontinuierliche Spannung zwischen einem zweiten positiven Potenzial und Masse definiert ist, wobei die Platine (1) Folgendes umfasst:
- eine erste elektrisch leitfähige Schicht (16) auf dem ersten positiven Potenzial,
- eine zweite elektrisch leitfähige Schicht (17) auf dem zweiten positiven Potenzial,
- eine dritte elektrisch leitfähige Schicht (18) auf Masse,
wobei mindestens zwei der elektrisch leitfähigen Schichten (16, 17, 18), insbesondere alle elektrisch leitfähigen Schichten, sich mindestens über eine Oberfläche erstrecken, die dem ersten Polygon (P1) überlagert ist.

11. Elektronische Platine nach den Ansprüchen 9 und 10, wobei eines der ersten, zweiten, dritten und vierten Polygone alle anderen Polygone enthält, und mindestens zwei der elektrisch leitfähigen Schichten, insbesondere alle elektrisch leitfähigen Schichten, sich mindestens über eine Oberfläche erstrecken, die diesem Polygon überlagert ist, in dem alle anderen Polygone enthalten sind.

12. Elektronische Platine nach Anspruch 10 oder 11, wobei jeder Kondensator der Vielzahl von Kondensatoren (11), die das zweite Polygon (P2) definieren, einen Anschluss hat, der elektrisch mit der ersten elektrisch leitfähigen Schicht (16) verbunden ist, und seinen anderen Anschluss elektrisch mit der dritten elektrisch leitfähigen Schicht (18) verbunden hat, und jeder Kondensator (12) der Vielzahl von Kondensatoren, die das dritte Polygon (P3) definieren, einen Anschluss hat, der elektrisch mit der zweiten elektrisch leitfähigen Schicht (17) verbunden ist, und seinen anderen Anschluss elektrisch mit der dritten elektrisch leitfähigen Schicht (18) verbunden hat.

13. Spannungswandler, insbesondere DC/DC, insbesondere 12V/48V DC/DC Spannungswandler, umfassend eine elektronische Platine nach einem der vorhergehenden Ansprüche.

## Claims

1. Electronic board (1), defining several switching arms (6) connected in parallel to convert a first voltage into a second voltage, one of these voltages being at least a continuous voltage, the board comprising:
- a plurality of electronically controllable switches (10) arranged two by two in series on either side of a midpoint, so as to form the switching arms connected in parallel,
- a plurality of decoupling capacitors (11, 12), these capacitors (11) being connected in parallel with each other, and in parallel with the continuous voltage, and **characterized by**
- two electrically conductive layers (16, 17, 18), notably arranged in parallel between them, one of these electrically conductive layers (16) being electrically at the higher potential of the continuous voltage and the other of these electrically conductive layers (18) being at the lower potential of the continuous voltage, each of the decoupling capacitors (11, 12) having one terminal connected to one of the electrically conductive layers (16) and another terminal connected to the other of the electrically conductive layers (18),
the electronic switches (10) being arranged on the board so that the pattern connecting all the midpoints of the switching arms (6) defines a first polygon (P1) whose number of corners is greater than or equal to 3, and each of the two electrically conductive layers (16, 17, 18) extending at least over a surface superimposed on the first polygon (P1).

2. Electronic board according to claim 1, wherein each electronically controllable switch (10) of a switching arm occupies one of: a position farther from the center of the first polygon (P1) relative to the midpoint of said arm, and a position closer to the center of the first polygon (P1) relative to said midpoint.

3. Electronic board according to claim 1 or 2, the decoupling capacitors (11) being arranged on the board so that the pattern connecting all these capacitors defines a second polygon (P2), the second polygon being notably of the same type as the first polygon (P1).

4. Electronic board according to claim 3, the second polygon (P2) being contained within, or at least mostly within, the first polygon (P1), or the first polygon (P1) being contained within, or at least mostly within, the second polygon (P2).

5. Electronic board according to any of the preceding claims, each of the first voltage and the second voltage being a continuous voltage, the first continuous voltage being notably higher than the second continuous voltage.

6. Electronic board according to claim 5, comprising a plurality of decoupling capacitors (11) connected in parallel with each other, and in parallel with the first voltage, and a plurality of decoupling capacitors (12) connected in parallel with each other and in parallel with the second continuous voltage, one of the pluralities of capacitors (11) being arranged on the board so that the pattern connecting all these capacitors defines the second polygon (P2) and the other plurality of capacitors (12) being arranged on the board so that the pattern connecting all these capacitors defines a third polygon (P3), the third polygon being notably of the same type as the first and second polygons.

7. Electronic board according to claim 6, the third polygon (P3) being contained inside, or at least mostly inside, the first polygon (P1), or the first polygon (P1) being contained inside, or at least mostly inside, the third polygon (P3).

8. Electronic board according to claim 6, the second polygon (P2) being contained inside, or at least mostly inside, the first polygon (P1), and the first polygon (P1) being contained inside, or at least mostly inside, the third polygon (P3).

9. Electronic board according to any one of claims 6 to 8, comprising a plurality of inductances (13), each inductance (13) being associated with a switching arm (6) and electrically connected to the midpoint of said arm, the inductances (13) being arranged on the board so that the pattern connecting all these inductances defines a fourth polygon (P4), the fourth polygon being notably of the same type as the first polygon.

10. Electronic board according to any one of claims 6 to 9, the first continuous voltage being defined between a first positive potential and the ground, and the second continuous voltage being defined between a second positive potential and the ground, the board (1) comprising:
- a first electrically conductive layer (16) at the first positive potential,
- a second electrically conductive layer (17) at the second positive potential,
- a third electrically conductive layer (18) at ground
at least two of the electrically conductive layers (16, 17, 18), notably all the electrically conductive layers, extending at least over a surface superimposed on the first polygon (P1).

11. Electronic board according to claims 9 and 10, one of the first, second, third and fourth polygons containing all the other polygons, and at least two of the electrically conductive layers, notably all the electrically conductive layers, extending at least over a surface superimposed on this polygon inside which are arranged all the other polygons.

12. Electronic board according to claim 10 or 11, each capacitor of the plurality of capacitors (11) defining the second polygon (P2) having one terminal electrically connected to the first electrically conductive layer (16) and its other terminal electrically connected to the third electrically conductive layer (18), and each capacitor (12) of the plurality of capacitors defining the third polygon (P3) having one terminal electrically connected to the second electrically conductive layer (17) and its other terminal electrically connected to the third electrically conductive layer (18).

13. Voltage converter, notably DC/DC, notably 12V/48V DC/DC voltage converter, comprising an electronic board according to any of the preceding claims.
